# EUROPÄISCHE PATENTSCHRIFT

(11) **EP 0 631 098 B1**
(45) Veröffentlichungstag und Bekanntmachung des Hinweises auf die Patenterteilung: **16.09.1998**
(21) Anmeldenummer: 94810350.2
(22) Anmeldetag: 14.06.1994
(51) Int. Cl.: F26B 3/30, F26B 15/12

(54) **Durchlauftrockner für plattenförmiges Stückgut und einen derartigen Durchlauftrockner enthaltende Beschichtungsanlage**
Continuous dryer for plane-shaped articles, and coating apparatus incorporating such a continuous dryer
Sécheur en continu pour articles de forme plane, et installation de revêtement incorporant un tel sécheur

(30) Priorität: 22.06.1993 CH 1868/93
(43) Veröffentlichungstag der Anmeldung: 28.12.1994
(73) Patentinhaber: Ciba Specialty Chemicals Holding Inc., 4057 Basel (CH)
(72) Erfinder: Kapp-Schwoerer, Diethard, D-79594 Inzlingen (DE); Krauss, Rainer, D-74223 Flein (DE)
(74) Vertreter: Zumstein, Fritz, Dr.

(56) Entgegenhaltungen:
- EP-A- 0 437 272
- EP-A- 0 507 218
- DE-A- 1 805 162
- DE-B- 1 031 264
- GB-A- 849 403
- GB-A- 1 115 794
- US-A- 1 560 589
- US-A- 2 391 195
- K. Kröll, "Trocknungstechnik", Zweiter Band, Springer-Verlag, 1978, Seiten 403-405

## Beschreibung

Die Erfindung betrifft einen Durchlauftrockner nach dem Oberbegriff des Anspruchs 1 sowie eine Beschichtungsanlage nach dem Oberbegriff des Anspruchs 8.

Ein Durchlauftrockner entsprechend dem Oberbegriff des Anspruchs 1 ist aus DE-A-1 805 162 bekannt, der mit Umluft unter Zusatz von Frischluft betrieben wird. Neben dem Trockenraum ist ein Luftführungskanal vorgesehen, wobei über die Länge des Trockenraumes verteilt mindestens zwei mit dem Luftführungskanal in Verbindung stehende Öffnungen vorgesehen sind, durch welche der Trockenraum in mehrere Zonen unterteilt wird. In diesen Zonen herrschen im allgemeinen stark unterschiedliche Luftgeschwindigkeiten. Im Trockenraum vorgesehene Infrarotstrahler dienen lediglich dazu, die Strömungsgeschwindigkeit der Luft in den einzelnen Zonen zu steigern.

Aus EP-A-0 437 272 ist ein Trockenschacht aus einem lotrecht aufgestellten Behandlungskanal für eine Warenbahn bekannt, die innerhalb des Kanals beidseitig mit Strahlungsheizkörpern aufgeheizt wird. Zum Abtransport des beim Trocknen sich bildenden Wasserdampfes dient bei dieser Vorrichtung allein Frischluft, die auf der Oberseite des Schachtes und auf der Rückseite der Strahlungsheizkörper angesaugt wird.

Aus US-A-1,560,589 ist ferner ein Verfahren zum Trocknen von mit einer flüchtigen Flüssigkeit behaftetem Material bekannt, das durch eine Trocknungskammer geführt wird, wobei auf beiden Seiten des bahnförmigen Materials Luft in Richtung der Bewegung der Materialbahn entlanggeführt wird.

Schließlich zeigt DE-B-1 031 264 eine Vorrichtung zum Behandeln von textilem Gut mit gasförmigen Mitteln, wobei in einem Trocknungskanal in Bewegungsrichtung des Textilgutes Luft geführt wird und Infrarotstrahler in dem Trocknungskanal angeordnet sein können.

Zur Herstellung der Leiterbahnen auf Leiterplatten oder bei mehrschichtigen Leiterplatten auf den sogenannten Innenlagen (In-Layers) werden die üblicherweise kupferkaschierten Epoxidharzglasfasergewebe mit einem Photolack oder mit einer ähnlichen lichtempfindlichen und entwickelbaren Polymerschicht beschichtet. Die gewünschte Leiterbahnenstruktur wird auf die getrocknete Beschichtung aufbelichtet, und die Beschichtung wird an den belichteten (oder je nach Photolacktyp an den unbelichteten) Stellen herausentwickelt. Bei dem nachfolgenden Ätzprozess wird das Kupfer an den freigelegten Stellen weggeätzt, die beschichteten Stellen hingegen sind gegen den Ätzangriff geschützt. Nach dem Ablösen der restlichen Beschichtung liegt die Innenlage bzw. die Leiterplatte mit der gewünschten Leiterbahnenstruktur vor.

Die Beschichtung und die Trocknung der Innenlagen bzw. der Leiterplatten erfolgt in einer Beschichtungsanlage. Diese umfasst üblicherweise eine Beschichtungsstation, in der die Innenlagen bzw. die Leiterplatten ein- oder beidseitig mit Photolack oder ähnlichem beschichtet werden, und wenigstens eine Trocknungsstationen, in welcher der Photolack getrocknet wird, und dabei abdampfendes Lösungsmittel (welches auch Wasser sein kann) von der Innenlage bzw. der Leiterplatte weg und zur Abluft transportiert wird.

Um den gewünschten Durchsatz zu erreichen, müssen die Innenlagen bzw. die Leiterplatten in einer verhältnismässig kurzen Zeit getrocknet werden. Zu diesem Zweck sind die Trockenstationen üblicherweise als Durchlauftrockner ausgebildet, in denen das beschichtete plattenförmige Stückgut während seines Transports von einer Einlauföffnung zu einer Ausgabeöffnung getrocknet wird. Die Trocknung der Beschichtung erfolgt üblicherweise in einem heissen Luftstrom, der über die Plattenoberfläche geführt wird. Es gibt auch Durchlauftrockner, in denen die Beschichtung mit Hilfe von infraroter Strahlung (IR-Strahlung) getrocknet wird. Diesen Infrarot-Trocknern sind in der Regel Umlufttrockner vorgeschaltet, um in der Beschichtung vorhandenes Lösungsmittel abzudampfen und wegzutransportieren. Diese Vortrocknung ist bei den konventionellen Infrarot-Trocknern aus Sicherheitsgründen unbedingt erforderlich, da sich ohne sie die erst im Infrarot-Trockner aus- und abgedampften Lösungsmitteldämpfe bei Kontakt mit der heissen Oberfläche der Infrarotstrahler entzünden können.

Ein wesentlicher Faktor, der die Dauer der Trocknung der Beschichtung bestimmt, ist die Temperatur innerhalb des Durchlauftrockners. Diese kann nicht beliebig hoch eingestellt werden, da dabei die Gefahr besteht, dass sich die Lösungsmitteldämpfe entzünden. Beim Einsatz von Infrarottrocknern besteht die Gefahr, dass die Beschichtung Blasen (Kochblasen) bildet, was die Gleichmässigkeit und die Qualität der Beschichtung stark beeinträchtigt und dazu führen kann, dass eine derartig beschichtete Innenlage bzw. Leiterplatte unbrauchbar wird. Daher sind der Verkürzung der Durchlaufzeiten bei konventionellen bekannten Durchlauftrocknern Grenzen gesetzt.

Ein weiteres Problem bei den bekannten Beschichtungsanlagen und insbesondere auch bei den bekannten konventionellen Trocknern stellt die Abgabe von Lösungsmitteldämpfen an die Umgebung dar. Diese können durch die Einlauföffnungen bzw. die Ausgabeöffnungen der einzelnen Stationen austreten, und die Umgebung beeinträchtigen. In gleichem Umfang wie Lösungsmitteldämpfe durch die Einlauf- bzw. die Ausgabeöffnungen der Stationen abgegeben werden, können bei den bekannten Beschichtungsanlagen aber auch Verunreinigungen in die Anlage gelangen. Diese Verunreinigungen können sich auf der Beschichtung niederschlagen und deren Qualität entscheidend beeinträchtigen. Beispielsweise können Partikel in der Beschichtung als Streuzentren im Belichtungsschritt wirken oder gar einzelne Bereiche maskieren, sodass die vorgegebene Leiterbahnenstruktur nicht vollständig auf den Photolack abgebildet wird. In den nachfolgenden Bearbeitungsschritten wird dann die kupferkaschierte Schicht fehlerhaft geätzt und eine unbrauchbare Leiterplatte hergestellt.

Es ist daher die Aufgabe der vorliegenden Erfindung, den vorstehend geschilderten Nachteilen des Standes der Technik abzuhelfen. Es soll ein Durchlauftrockner geschaffen werden, der einen schnellen Durchsatz, das heisst eine schnelle Trocknung, der Innenlagen bzw. der Leiterplatten erlaubt, ohne dabei die Qualität der Beschichtung zu beeinträchtigen. Der Durchlauftrockner soll den Anforderungen hinsichtlich des Explosionsschutzes genügen, eine Entzündung des während der Trocknung aus- bzw. abgedampften Lösungsmittels soll vermieden werden. Zudem soll bei dem Trockner die unerwünschte Abgabe von Lösungsmitteldämpfen an die Umgebung weitgehend vermieden werden. Die Konzeption des Trockners soll die Bereitstellung einer Beschichtungsanlage erlauben, die gegenüber der Umgebung weitgehend gekapselt ist. Die Beschichtungsanlage soll die Realisierung relativ hoher Reinraumqualitäten innerhalb der Anlage erlauben, und unerwünschte Emissionen nach aussen sollen weitgehend unterbunden sein. Der Trockner und die Beschichtungsanlage sollen energiesparend betreibbar sein. Zudem sollen sowohl der Durchlauftrockner alsauch die Beschichtungsanlage kompakt in ihren Dimensionen und kostengünstig von der Konzeption und im Betrieb sein.

All diese Aufgaben werden durch einen Durchlauftrockner gemäss dem kennzeichnenden Teil des Patentanspruchs 1 und durch eine Beschichtungsanlage gelöst, welche die kennzeichnenden Merkmale des Patentanspruchs 8 aufweist. Besonders bevorzugte und vorteilhafte Ausführungsvarianten sind jeweils gegenstand der abhängigen Patentansprüche.

Insbesondere wird durch die Erfindung ein Durchlauftrockner für plattenförmiges Stückgut, insbesondere für beschichtete Innenlagen oder Leiterplatten, geschaffen, der eine Trocknungskammer aufweist, in der das zu trocknende plattenförmige Stückgut einem zwangsgeführten Luftstrom ausgesetzt ist während es von vorzugsweise an seinen Längsrändern angreifenden Transportmitteln entlang einer Transportbahn von einem Eingang zu einem Ausgang der Trocknungskammer transportiert wird. Die Trocknungskammer ist mit einem Einlass für Zuluft und mit einem Auslass für Abluft ausgestattet. Ober- und unterhalb der Transportbahn des plattenförmigen Stückguts sind Infrarotstrahler angeordnet, deren Strahlung unmittelbar auf das beschichtete Stückgut einwirkt und die zudem eine Wärmequelle für den zwangsgeführten Luftstrom bilden. Der Luftstrom in der Trocknungskammer ist entgegen der Transportrichtung des plattenförmigen Stückguts und im wesentlichen parallel zu der Transportebene zwangsgeführt. Die Beschichtungsanlage ist mit einem derartigen Durchlauftrockner ausgestattet.

Im folgenden wird eine beispielsweise Ausführungsform der Erfindung unter Bezugnahme auf die schematischen Zeichnungen und Diagramme näher erläutert. Es zeigen:
- Fig. 1: eine Beschichtungsanlage umfassend eine Beschichtungsstation und einen Durchlauftrockner,
- Fig. 2: die Luftströmung in der Beschichtungsstation gemäss Fig. 1, und
- Fig. 3a-c: eine Anordnung von 3 Heizzonen im Durchlauftrockner (a), ein zugehöriges Temperaturdiagramm der Infrarotstrahler in den Heizzonen (b), und ein zugehöriges Diagramm der Temperatur der Konvektionsströmung in den drei Heizzonen (c).

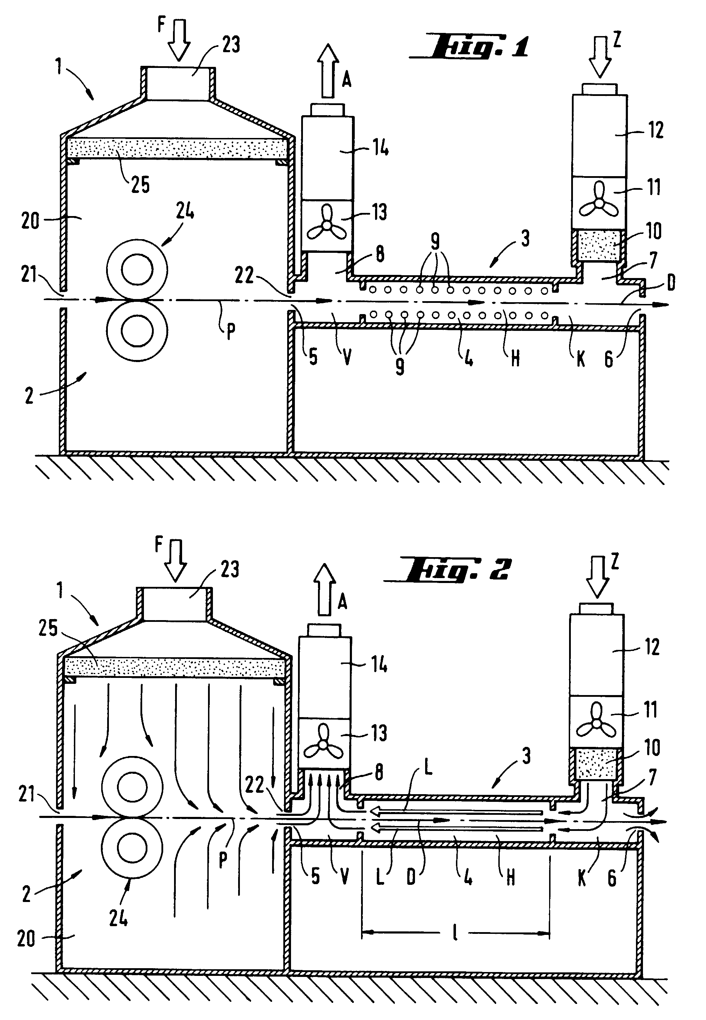

Eine beispielsweise Ausführungsvariante einer Beschichtungsanlage für plattenförmiges Stückgut, insbesondere für Innenlagen bzw. Leiterplatten ist in den Fig. 1 und 2 jeweils gesamthaft mit dem Bezugszeichen 1 versehen. Sie umfasst eine Beschichtungsstation 2, in der das plattenförmige Stückgut mit Photolack oder ähnlichem beschichtet wird, und eine Trocknungsstation 3, in der das beschichtete Stückgut getrocknet wird. Bei der Trocknungsstation handelt es sich insbesondere um einen horizontalen Durchlauftrockner mit einer Trocknungskammer 4, welche das beschichtete Stückgut liegend entlang einer im wesentlichen horizontalen Transportbahn P in Transportrichtung D von einem Eingang 5 zum Ausgang 6 durchläuft. Für den Transport des beschichteten Stückgutes ist der Durchlauftrockner 3 mit nicht dargestellten Transportmitteln an sich bekannter Art ausgestattet. Beispielsweise handelt es sich dabei um Halteklammern, die an endlos umlaufenden Transportketten oder -seilen montiert sind, und die das beschichtete plattenförmige Stückgut üblicherweise an den Längsrändern halten. Ein Einlass 7 für Zuluft Z und ein Auslass für Abluft A erlauben die Zirkulation einer Luftströmung L in der Trocknungskammer.

In der Trocknungskammer 4 sind ober und unterhalb der Transportbahn P des beschichteten plattenförmigen Gutes Infrarotstrahler 9 angeordnet, die sich vorzugsweise parallel zur Transportbahn P und quer zur Transportrichtung D erstrecken. Die Anzahl der Infrarotstrahler 9 oberhalb der Transportbahn P entspricht der Anzahl unterhalb der Transportbahn. Insbesondere liegen einander jeweil ein oberer und ein unterer Infrarotstrahler genau gegenüber. Die Infrarotstrahler 9 sind vorzugsweise in gleichbleibenden Abständen voneinander entlang der Transportbahn D angeordnet. Der Abstand zweier nebeneinander angeordneter Infrarotstrahler beträgt dabei etwa 70 mm bis 130 mm, vorzugsweise etwa 100 mm. Die Infrarotstrahler 9 sind aus Gründen der besonders einfachen Konstruktion jeweils an der oberen bzw. der unteren Begrenzungswand der Trocknungskammer 4 angebracht. Die (nicht dargestellten) Transportmittel für das beschichtete Stückgut sind derart angeordnet, dass die Transportbahn P des plattenförmigen Guts etwa in der Mitte zwischen der oberen und der unteren Begrenzugswand der Trocknungskammer 4 verläuft. Auf diese Weise kann das Temperaturprofil in der Trocknungskammer sehr gut kontrolliert werden.

Der Einlass 7 für die Zuluft Z ist in der Nähe des Ausgangs 6 aus der Trocknungskammer 4 angeordnet, während der Auslass 8 für die Abluft A in der Nähe des Eingangs 5 in die Trocknungskammer 4 vorgesehen ist. Die über den Einlass 7 eingebrachte Zuluft Z strömt in der Trocknungskammer 4 gegen die Transportrichtung D des beschichteten plattenförmigen Gutes. Insbesondere verläuft der Luftstrom L in der Trocknungskammer 4 etwa parallel zu der Transportbahn P. Auf diese Weise wird das von der trocknenden Beschichtung aus- und abgedampfte Lösungsmittel vom Luftstrom vom Ausgang 6 der Trocknungskammer 4 weg zum Eingang 5 der Trocknungskammer 4 mitgenommen und dort über den Auslass 8 für die Abluft A abgesaugt.

Die Trocknungskammer 4 des Durchlauftrockners 3 ist in drei Bereiche unterteilt. Direkt im Anschluss an den Eingang 5 für das plattenförmige Gut ist ein Vorwärm- und Mischbereich V vorgesehen. Im Anschluss daran ist ein eigentlicher Heizbereich H mit den Infrarotstrahlern 9 angeordnet. Der letzte Bereich ist ein Kühlbereich K, der sich vom Ende des Heizbereichs H bis zum Ausgang 6 aus der Trocknungskammer 4 erstreckt. Die Funktion dieser drei Bereiche ist bereits aus ihren Bezeichnungen ablesbar. Im Vorwärm- und Mischbereich V wird das über den Eingang 5 einlaufende beschichtete Stückgut vom aus dem Heizbereich H kommenden Luftstrom L vorgewärmt. Im Heizbereich H erfolgt die eigentliche Trocknung der Beschichtung einerseits durch die direkte Strahlungseinwirkung der Infrarotstrahler 9, andererseits durch den über die beschichteten Oberflächen streichenden erwärmten Luftstrom L. Der Luftstrom L wird dabei allein durch die Heizleistung der Infrarotstrahler 9 erwärmt. Im Anschluss an den Heizbereich wird das getrocknete plattenförmige Stückgut im Kühlbereich K von der eingebrachten Zuluft, die üblicherweise auf Umgebungstemperatur oder kontrolliert auf etwa 25°C gehlaten wird, gekühlt bevor es durch den Ausgang 6 der Trocknungskammer 4 ausgegeben wird.

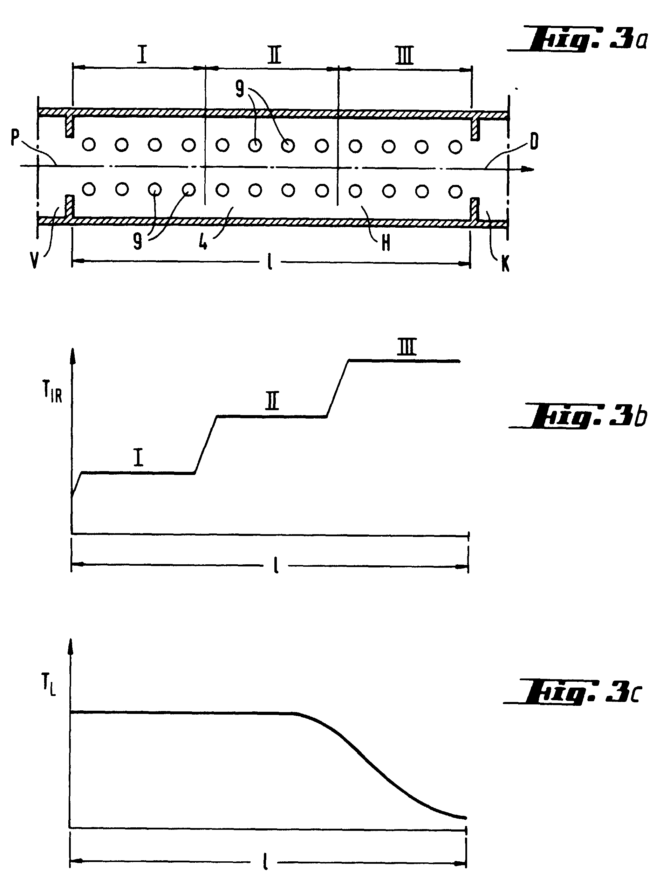

Der Heizbereich H der Trocknungskammer 4 ist in weitere Zonen unterteilt, in denen unterschiedliche Temperaturen einstellbar sind. Dazu sind die oberhalb und unterhalb der Transportbahn P angeordneten Infrarotstrahler 9 gruppenweise zusammengefasst. Gemäss der Darstellung in Fig. 3a sind auf diese Weise drei Heizzonen I,II,III gebildet. Die Infrarotstrahler 9 der jeweiligen Heizzone werden mit unterschiedlichen Leistungen betrieben, sodass sie in den HeizzonenI,II,III unterschiedliche Oberflächentemperaturen T_{IR} aufweisen, wie im Diagramm in Fig. 3b angedeutet. Dabei ist die Heizzone I mit der tieferen Oberflächentemperatur T_{IR} der Infrarotstrahler 9 dem Eingang 5 in die Trocknungskammer 4 am nächsten, während die Heizzone III mit der höchsten Oberflächentemperatur T_{IR} der Infrarotstrahler 9 in der Nähe des Ausgangs 6 liegt bzw. an den Kühlbereich K anschliesst. In der dazwischen liegenden Heizzone II haben die Infrarotstrahler eine Oberflächentemperatur T_{IR}, die zwischen derjenigen der ersten I und der letzten Heizzone III liegt. Für den Fall, dass mehr als drei Heizzonen vorgesehen sind, ist immer jeweils die Oberflächentemperatur T_{IR} der Infrarotstrahler 9 in der nachfolgenden Heizzone grösser als diejenige in der vorangehenden Heizzone.

In Fig. 3c ist der Temperaturverlauf T_{L} des Luftstroms L über die Länge 1 des Heizbereichs H diagrammatisch festgehalten.Es ist klar ersichtlich, das dieser dem Verlauf der Oberflächentemperatur T_{IR} der Infrarotstrahler 9 in den einzelnen Zonen I,II,III des Heizbereichs H entgegenläuft. Die Zuluft Z wird bei etwa 25°C eingebracht. Während des Durchströmens des Heizbereichs H im Gegenstrom zur Transportrichtung D des plattenförmigen Stückgutes wird sie von den Infrarotstrahlern 9 aufgeheizt. Dabei trifft sie zunächst auf die Infrarotstrahler 9 mit der höchsten Oberflächentemperatur und wird von diesen sehr schnell auf die erforderliche Solltemperatur von beispielsweise etwa 110°C bis 130°C aufgeheizt. Diese Temperatur behält der Luftstrom L bis zu seinem Austreten aus dem Heizbereich H bei, da die Oberflächentemperatur T_{IR} der Infrarotstrahler 9 in der ersten Heizzone grösser als diese Solltemperatur ist und beispielsweise 180°C bis 220°C beträgt.

Die gegenläufigen Temperaturprofile der Oberflächentemperaturen T_{IR} der Infrarotstrahler 9 und der Temperatur T_{L} des Luftstroms L über die Länge 1 des Heizbereichs H erlauben eine besonders schonende und zugleich effiziente Trocknung des nassbeschichteten plattenförmigen Stückgutes. Dieses wird beim Durchlaufen der Trocknungskammer gegebenfalls zunächst in der Vorwärm- und Mischkammer V ansonsten beim Eintritt in die erste Heizzone I vorgewärmt. In dieser ersten Heizzone I ist die Oberflächentemperatur T_{IR} der Infrarotstrahler 9 relativ gering, hingegen hat die Temperatur T_{L} des Luftstroms L, der aus dem Heizbereich H austritt, seine Solltemperatur. In dieser ersten Heizzone I erfolgt eine erste Vortrocknung der Beschichtung im wesentlichen durch die über die Oberfläche des plattenförmigen Stückgutes strömende Heissluft L. Eine Blasenbildung der Beschichtung durch eine hohe Strahlungsleistung der Infrarotstrahler 9 wird auf diese Weise zuverlässig vermieden. In der zweiten Heizzone II erfolgt die Trocknung etwa zu gleichen Teilen durch die unmittelbare Strahlungsleistung der Infrarotstrahler 9, die in dieser Heizzone beispielsweise eine Oberflächentemperatur T_{IR} von etwa 240°C bis 260°C aufweisen können. In der dritten Heizzone III schliesslich erfolgt die Nachtrocknung praktisch auschliesslich durch die Strahlungsleistung der Infrarotstrahler 9. Die einströmende noch kalte Zuluft Z hingegen dient zur Abkühlung des plattenförmigen Gutes. Gegebenefalls ist im Anschluss an die dritte Heizzone III die Kühlzone K angeschlossen, in der keine Infrarotstrahler angeordnet sind, und das plattenförmige Stückgut nur mehr der einströmenden relativ kühlen Zuluft Z ausgesetzt ist.

Die Luftströmung L in der Trocknungskammer 4 wird im wesentlichen davon bestimmt, wie gross die Menge an zugeführter Zuluft Z und wie gross das abgeführte Abluftvolumen A ist. Vorzugsweise ist der Luftauslass 8 für den Abzug einer grösseren Luftmenge ausgebildet als am Einlass 7 Zuluft zugeführt wird. Vorzugsweise wird dieses Luftmengenverhältnis derart geregelt, dass die Luftströmung L in der Trocknungskammer 4 im wesentlichen laminar ist. Die laminare Luftströmung L hat den Vorteil, dass alle Bereiche der Oberflächen des zu trocknenden beschichteten plattenförmigen Stückgutes von der gleichen Luftmenge überstrichen werden und auf diese Weise eine sehr gleichmässige Trocknung erzielt werden kann. Die laminare Luftströmung gewährleistet auch, dass aus- oder abgedampftes Lösungsmittel zuverlässig von den Oberflächen des Stückgutes wegtransportiert wird und nicht in Wirbelbereichen innerhalb der Trocknungskammer festgehalten wird.

Das Einbringen der Zuluft Z bzw. die Absaugung der Abluft A kann über externe Fördermittel erfolgen, vorzugsweise jedoch sind die Fördermittel 11, 13 für die Zu- bzw. Abluft im Lufteinlass 7 bzw. dem Luftauslass 8 der Trocknungskammer 4 vorgesehen. Zur Sicherstellung der Konstanz der am Einlass 7 eingebrachten Zuluftmenge Z und der am Auslass 8 abgesaugten Abluftmenge A sind am Einlass 7 wie am Auslass 8 Durchflussmengenregler 12 bzw. 14 für die Luft vorgesehen. Auf diese Weise können die Strömungsverhältnisse in der Trocknungskammer 4 exakt geregelt werden, was für die Aufrechterhaltung der vorzugweise laminaren Luftströmung L sehr von Vorteil ist.

Um zu verhindern, dass mit der Zuluft Z auch Verunreinigungen, Partikel etc. in die Trocknungskammer 4 gelangen, ist im Einlass 7 für die Zuluft Z vorzugsweise ein Reinraumfilter 10 angebracht. Die Art des Reinraumfilters 10 hängt dabei davon ab, welche Reinraumklasse in der Trocknungskammer 4 erreicht werden soll.

Die erfindungsgemässe Beschichtungsanlage 1 für plattenförmiges Stückgut, insbesondere für Innenlagen oder Leiterplatten, weist einen Durchlauftrockner 3 der beschriebenen Art auf, in dem die Beschichtung schonend getrocknet wird und in der Beschichtung enthaltenes Lösungsmittel abgedampft und weggeführt wird. Die Beschichtungsstation 2 der Beschichtungsanlage 1 umfasst eine Beschichtungskabine 20 mit einer Einttrittsöffnung 21 für das zu beschichtende plattenförmige Stückgut. An der gegenüberliegenden Seite der Beschichtungskabine 20 ist eine Austrittsöffnung 22 vorgesehen, die unmittelbar in den eingang 5 der Trocknungskammer 4 mündet. Über eine Zuluftöffnung 23, die vorzugsweise im Deckenbereich der Beschichtungskabine 20 vorgesehen ist, kann Luft F in die Beschichtungskabine 20 eingeblasen werden.

Innerhalb der Beschichtungskabine 20 ist eine Walzenbeschichtungseinrichtung 24 angeordnet. Diese umfasst je eine ober bzw. unterhalb der Transportbahn P des plattenförmigen Stückguts angeordnete Beschichtungswalze, zwischen denen das plattenförmige Stückgut zur Beschichtung mit dem Photolack oder ähnlichem hindurchtransportiert wird. Bei dieser Form der Beschichtung werden beide Oberflächen der Innenlagen bzw. der Leiterplatten gelichzeitig gleichmässig beschichtet. Dabei wird es von in der Beschichtungkabine 20 vorgesehenen Transportmitteln an den Längsrändern gehalten. Diese Transportmittel können analog zu den Transportmitteln in der Tocknungsstation 3 ausgebildet sein; da sie für die Erfindung nicht weiter vn Bedeutung sind, wurde auf ihre Darstellung in den Fig. verzichtet.

Die über die Zuluftöffnung 23 eingebrachte Luft F, die üblicherweise auf Umgebungstemperatur oder etwa suf 25°C gehalten wird, gelangt durch die Austrittsöffnung 22 zum Auslass 8 der Trocknungskammer 4 für die Abluft A der Trocknungskammer. Auf diese Weise besitzt die gesamte Beschichtungsanlage 1 nur einen einzigen Auslass 8 für die mit Lösungsmitteldämpfen verstzte Abluft, die einerseits aus der Trocknungstation 3, andererseits aber auch aus der Beschichtungsstation 2 kommt.

Die Absaugleistung an der Auslassöffnung 8 ist dabei derart geregelt, dass das ausgetragene Abluftvolumen A etwa den Luftvolumina der durch die Trockenkammer 4 geführten Luft L und der in die Beschichtungskabine 20 eingeblasenen Luft F entspricht.

Das Mischverhältnis der Luftvolumina der aus der Trocknungskammer 4 stammenden Heissluft L und der kalten Luft F aus der Beschichtungskabine ist derart bemessen, dass die Abluft A am gemeinsamen Auslass 8 nur noch eine Temperatur von etwa 30°C bis 70°C aufweist, während die Temperatur der Trocknungsluft in der Trocknungskammer 4 noch etwa 110°C bis 130°C beträgt. Dadurch kann auf besondere Massnahmen, die abgesaugte Abluft A, die mit Lösungsmitteldämpfen versehen sind, gegen Selbstentzündung zu schützen, weitgehend verzichtet werden.

Um auch die Beschichtungskabine 20 frei von Verunreinigungen, Partikeln etc. zu halten, kann in der Zuluftöffnung 23 ein Reinraumfilter 25 vorgesehen sein. Wie bereits im Zusammenhang mit dem Reinraumfilter 10 im Einlass für die Zuluft zur Trocknungskammer erwähnt, hängt die Wahl des Reinraumfiltertyps von der Reinraumqualität ab, die erzielt werden soll.

Die Reinraumqualität kann noch verbessert werden, indem die Beschichtungsanlage 1 gegenüber der Umgebung luftmässig abgeschottet wird. Dazu erfolgt die Luftführung in der Beschichtungsanlage derart, dass in der Beschichtungskabine 20 im Bereich der Eintrittsöffnung 21 und in der Trocknungskammer 4 im Bereich des Ausgangs 6 jeweils ein kleiner Überdruck herrscht. Dieser leicht Überdruck verhindert, dass Umgebungsluft durch die Eintrittsöffnung 21 bzw. durch den Ausgang 6 in die Beschichtungsanlage gelangen kann. Die kleinen Mengen der in die Beschichtungskabine 20 eingebrachten Luft F bzw. der in die Trochnungskammer 4 eingebrachten Zuluft Z, die jeweils durch die Eintrittsöffnung 21 bzw. durch den Ausgang 6 in die Umgebung abgegeben werden, sind praktisch frei von Lösungsmitteldämpfen. Diese werden ja einerseits von der Luftströmung in der Beschichtungskabine 20 durch die Austrittsöffnung 22 und von der vorzugsweise laminaren Luftströmung L in der Trocknungskammer 4 zum Auslass 8 transportiert und dort abgesaugt. Auf diese Weise kann sowohl die Reinraumqualität in der Beschichtungsanlage 1 verbessert werden alsauch die Umgebung der Beschichtungsanlage 1 weitgehend frei von Lösungsmitteldämpfen gehalten werden.

Die erfindungsgemässe Beschichtungsanlage und der erfindungsgemässe Durchlauftrockner erlauben eine sehr kurze Durchlaufzeit des zu trocknenden nassbeschichteten Stückgutes. Beispielsweise können Innenlagen (kupferkaschiertes Laminat), die mit einem Photolack mit 50% Festkörper und Methoxybuthanol als Lösungsmittel mit einer Nassfilmdicke von 25 µm beschichtet sind, in weniger als 50 sec getrocknet werden. Die Länge der Trocknungskammer beträgt dabei beispielsweise etw 1.6 m bis 2.0 m, seine Breite etwa 0.9 m bis etwa 1.0 m und seine Höhe etwa 0.30 m bis 0.40 m. Die Grösse des Eingangs bzw. des Ausgangs der Trocknungskammer beträgt etwa 0.92 m bis etwa 0.98 m in der Breite, bei einer Höhe von etwa 0.13 m bis etwa 0.18 m. Der Abstand der Infrarotstrahler zu Substrat beträgt etwa 0.12 m bis 0.17 m. Als Infrarotstrahler werden beispielsweise Zwillingsrohrstrahler STM der Firma Heraeus Noblelight verwendet, die bei einer Leistung von 1200 Watt eine Strahlungsdichte von etwa 12 kW/m² aufweisen. Die Oberflächentemperaturen der Infrarotstrahler betragen in der ersten Heizzone beispielsweise etwa 200°C, in der zweiten etwa 250°C und in der dritten Heizzone knapp unter 300°C. Die in die Trocknungskammer bzw. in die Beschichtungskabine geführte Zuluft weist beispielsweise eine Temperatur von etwa 25°C auf. Dabei wird die Luftmenge am Einlass in die Trocknungskammer auf etwa 200 m³/h bis etwa 800 m³/h, vorzugsweise auf etwa 500 m³/h geregelt. Die Abluftmenge am Auslass wird auf etwa 1500 m³/h bis etwa 3000 m³/h, vorzugsweise etwa 2000 m³/h geregelt. Auf diese Weise ergibt sich am Auslass eine Ablufttemperatur von etwa 40°C bis 50°C, obwohl die Temperatur der Trocknungsluft in der dritten Heizzone noch etwa 120°C beträgt. Die Reinraumfilter sind beispielsweise ein papierartiges Glasfaservlies, welches gegenüber Partikel ≥ 0.3 µm einen Abscheidungsgrad von mehr als 99,99% aufweist. Auf diese Weise kann in der Beschichtungsanlage beispielsweise eine Reinraumqualität der Reinraumklasse 100 erzielt werden.

Die erfindungsgemässe Beschichtungsanlage und insbesondere der erfindungsgemässe Durchlauftrockner sind kompakt in den Abmessungen, verhältnismässig kostengünstig in der Herstellung und im Betrieb. Sie erlauben einen sehr raschen Durchsatz von Innenlagen bzw. Leiterplatten. Die Konzeption des Durchlauftrockners trägt auch den Erfordernissen hinsichtlich hinsichtlich der Sicherheit, insbesondere des Explosionsschutzes, Rechnung. Einerseits durchlaufen die Innenlagen bzw. die Leiterplatten eine Trocknungskammer mit steigendem Temperaturprofil. Am Eingang der Trocknungskammer, wo anfangs der Trocknung relativ viel Lösungsmittel ab- bzw. ausdampft, ist die Temperatur der Oberfläche der Infrarot-Strahler relativ niedrig. Die höchsten Oberflächentemperaturen weisen die Infrarotstrahler am Ausgang der Trocknungskammer auf, wo nur mehr wenig Lösungsmittel in der Beschichtung enthalten ist. Der Luftstrom in der Trocknungskammer ist der Transportrichtung der Innenlagen bzw. Leiterplatten entgegengerichtet. Dadurch ist sichergestellt, dass die Lösungsmitteldämpfe von den Heizzonen mit den Infrarotstrahlern mit den grösseren Oberflächentemperaturen wegtransportiert wird. Als weitere Sicherheitsmassnahme kann auch darauf geachtet werden, dass die Oberflächentemperatur der Infrarotstrahler 300°C nicht überschreitet. Die heisse Abluft des Durchlauftrockners wird mit der kalten Abluft der Beschichtungskabine gemischt. Dadurch wird die Temperatur der Abluft am Auslass niedriggehalten, was die Sicherheit der Anlage noch erhöht. Der Durchlauftrockner und die Beschichtungsanlage können bei nur geringem Energieaufwand mit sehr hoher Reinraumqualität betrieben werden. Das Lüftungskonzept des Durchlaufofens und insbesondere der Beschichtungsanlage bewirkt eine Abschottung gegenüber der Umgebung und verhindert auf diese Weise weitgehend die Abgabe von Lösungsmitteldämpfen an die Umgebung.

## Patentansprüche

1. Durchlauftrockner für plattenförmiges Stückgut, insbesondere für beschichtete Innenlagen von Leiterplatten, mit einer Trocknungskammer (4), in der das zu trocknende plattenförmige Stückgut einem zwangsgeführten Luftstrom (L) ausgesetzt ist, während es von vorzugsweise an seinen Längsrändern angreifenden Transportmitteln entlang einer Transportbahn (P) von einem Eingang (5) zu einem Ausgang (6) der Trocknungskammer (4) transportiert wird, und mit einem Einlaß (7) und einem Auslaß (8) für die Luft (L), wobei oberhalb der Transportbahn des plattenförmigen Stückguts Infrarotstrahler angeordnet sind, und der Luftstrom in der Trocknungskammer entgegen der Transportrichtung des plattenförmigen Stückguts und im wesentlichen parallel zu der Transportebene zwangsgeführt ist,
dadurch gekennzeichnet,
daß ober- und unterhalb der Transportbahn (P) des plattenförmigen Stückguts Infrarotstrahler (9) angeordnet sind, deren Strahlung unmittelbar auf das Stückgut einwirkt, um dieses zu trocknen, und die zugleich eine Wärmequelle für den zwangsgeführten Luftstrom (L) bilden,
daß der Luftstrom (L) in der Trocknungskammer (4) im wesentlichen laminar ist, und
daß die ober- und unterhalb entlang der Transportbahn (P) angeordneten Infrarotstrahler (9) gruppenweise zusammengefaßt und derart betreibbar sind, daß die Trocknungskammer (4) entlang der Transportbahn (P) mehrere, vorzugsweise drei Heizzonen (I,II,III) aufweist, die jeweils eine Gruppe von Infrarotstrahlern (9) mit einer unterschiedlichen Oberflächentemperatur aufweisen, wobei die Heizzone (I) mit der niedrigsten Oberflächentemperatur der Infrarotstrahler (9) dem Eingang (5) der Trocknungskammer (4) am nächsten liegt, während die Heizzone (III) mit der größten Oberflächentemperatur der Infrarotstrahler (9) die letzte Heizzone vor dem Ausgang (6) ist.

2. Vorrichtung nach Anspruch 1, dadurch gekennzeichnet, dass die Infrarotstrahler (9) in gleichbleibenden Abständen voneinander entlang der Transportbahn (P) angeordnet sind, wobei der Abstand zweier Infrarotstrahler (9) voneinander etwa 70 mm bis etwa 130 mm, vorzugsweise etwa 100 mm beträgt.

3. Vorrichtung nach Anspruch 1, dadurch gekennzeichnet, dass der Luftauslass (8) für den Abzug einer grösseren Luftmenge ausgebildet ist, als am Lufteinlass (7) zugeführt wird.

4. Vorrichtung nach Anspruch 1, dadurch gekennzeichnet, dass der Einlass (7) für die Zuluft (Z) im Bereich des Ausgangs (6) der Trocknungskammer (4) während der Auslass (8) für die Abluft (A) im Bereich des Eingangs (5) der Trocknungskammer (4) angeordnet ist, und dass am Einlass (7) wie am Auslass (8) Durchflussmengenregler (12;14) für die Luft vorgesehen sind.

5. Vorrichtung nach Anspruch 4, dadurch gekennzeichnet, dass im Einlass (7) für die Zuluft (Z) ein Reinraumfilter (10) angeordnet ist.

6. Vorrichtung nach Anspruch 1, dadurch gekennzeichnet, dass die Transportbahn (P) des plattenförmigen Gutes innerhalb der Trocknungskammer (4) im wesentlichen horizontal verläuft.

7. Vorrichtung nach Anspruch 1, dadurch gekennzeichnet, dass die Trocknungskammer (4) in drei Bereiche unterteilt ist, einen Vorwärm- und Mischbereich (V), der unmittelbar hinter dem Eingang (5) angeordnet ist, einen darauf folgenden Heizbereich (H), der gegebenenfalls in die drei Heizzonen (I,II,III) unterteilt ist, und einen Kühlbereich (K), der vor dem Ausgang (6) der Trocknungskammer (4) angeordnet ist.

8. Beschichtungsanlage für plattenförmiges Stückgut, insbesondere für Innenlagen oder Leiterplatten, mit einer Beschichtungsstation (2), in der das plattenförmige Stückgut ein oder beidseitig mit Photolack oder ähnlichem beschichtet wird, und mit einer daran anschliessenden Trocknungsstation (3), in welcher der Photolack getrocknet wird und im Photolack enthaltenes Lösungsmittel abgedampft und weggeführt wird, dadurch gekennzeichnet, dass die Trocknungsstation (3) ein Durchlauftrockner gemäss einem der Ansprüche 1-7 ist.

9. Beschichtungsanlage nach Anspruch 8, dadurch gekennzeichnet, dass die Beschichtungsstation (2) eine Beschichtungskabine (20) mit einer Zuluftöffnung (23) und mit einer Eintritts- (21) und einer gegenüberliegenden Austrittsöffnung (22) für das zu beschichtende plattenförmige Gut umfasst, wobei die Austrittsöffnung (22) unmittelbar in den Eingang (5) der Trocknungskammer (4) mündet.

10. Beschichtungsanlage nach Anspruch 9, dadurch gekennzeichnet, dass die Beschichtungsstation (2) mit einer Walzenbeschichtungseinrichtung (24) ausgestattet ist, die je eine ober bzw. unterhalb der Transportbahn (P) des plattenförmigen Stückguts angeordnete Beschichtungswalze umfasst, zwischen denen das plattenförmige Stückgut zur Beschichtung mit Photolack oder ähnlichem hindurchtransportierbar ist, wobei es von in der Beschichtungsstation (2) vorgesehenen Transportmitteln an den Längsrändern gehalten ist.

11. Beschichtungsanlage nach Anspruch 9, dadurch gekennzeichnet, dass die im Durchlauftrockner (3) vorgesehen Auslassöffnung (8) für die Abluft (A) zugleich die Abluftöffnung für die Beschichtungskabine (20) ist.

12. Beschichtungsanlage nach Anspruch 11, dadurch gekennzeichnet, dass das an der Auslassöffnung (8) ausgetragene Abluftvolumen (A) etwa den den Luftvolumina der durch die Trocknungskammer (20) geführten Trocknungsluft (L) und der in die Beschichtungskabine (20) eingetragenen Luft (F) entspricht.

13. Beschichtungsanlage nach Anspruch 12, dadurch gekennzeichnet, dass die Zuluftöffnung (23) der Beschichtungskabine (20) mit einem Reinraumfilter (25) ausgestattet ist.

14. Beschichtungsanlage nach Anspruch 13, dadurch gekennzeichnet, dass das Mischverhältnis von heisser Abluft aus der Trocknungskammer (4) und kalter Abluft aus des Beschichtungskabine (20) derart gewählt ist, dass die Abluft (A) an der Auslassöffnung (8) eine Temperatur von etwa 30°C-70°C aufweist.

15. Beschichtungsanlage nach Anspruch 11, dadurch gekennzeichnet, dass die Luftführung in der Anlage derart erfolgt, dass innerhalb der Beschichtungskabine (20) im Bereich der Eintrittsöffnung (21) und innerhalb der Trocknungskammer (4) im Bereich des Ausgangs (6) für das plattenförmige Stückgut ein kleiner Überdruck herrscht, sodass die Anlage gegenüber der Umgebungsluft im wesentlichen abgeschottet ist.

## Claims

1. A continuous drier for board-shaped piece material, especially for coated in-layers of printed circuit boards, comprising a drying chamber (4), in which the board-shaped piece material to be dried is exposed to a guided air stream (L) while being transported along a transport path (P) from an entrance (5) to an exit (6) of the drying chamber (4) by transport means acting preferably at its longitudinal edges, and comprising an inlet (7) and an outlet (8) for the air (L), infrared radiators being arranged above the transport path of the board-shaped piece material and the air stream being guided in the drying chamber counter to the transport direction of the board-shaped piece material and substantially parallel to the transport plane,
wherein
there are arranged above and below the transport path (P) of the board-shaped piece material infrared radiators (9) the radiation of which acts directly on the piece material in order to dry it and which, at the same time, form a heat source for the guided air stream (L), the air stream (L) in the drying chamber (4) is substantially laminar, and
the infrared radiators (9) arranged along the transport path (P) above and below the same are assembled into groups and can be operated in such a manner that the drying chamber (4) comprises several, preferably three, heating zones (I, II, III) along the transport path (P), each of which heating zones comprises a group of infrared radiators (9) having a different surface temperature, the heating zone (I) having the lowest surface temperature of the infrared radiators (9) being closest to the entrance (5) of the drying chamber (4), whilst the heating zone (III) having the highest surface temperature of the infrared radiators (9) is the last heating zone before the exit (6).

2. An apparatus according to claim 1, wherein the infrared radiators (9) are arranged at constant distances from one another along the transport path (P), the distance of two infrared radiators (9) from each other being from approximately 70 mm to approximately 130 mm, preferably approximately 100 mm.

3. An apparatus according to claim 1, wherein the air outlet (8) is designed to remove a greater quantity of air than is supplied at the air inlet (7).

4. An apparatus according to claim 1, wherein the inlet (7) for the incoming air (Z) is arranged in the region of the exit (6) of the drying chamber (4), whereas the outlet (8) for the outgoing air (A) is arranged in the region of the entrance (5) of the drying chamber (4), and wherein flow rate regulators (12; 14) for the air are provided at the inlet (7) and at the outlet (8).

5. An apparatus according to claim 4, wherein a clean-room filter (10) is arranged in the inlet (7) for the incoming air (Z).

6. An apparatus according to claim 1, wherein the transport path (P) of the board-shaped material inside the drying chamber (4) extends substantially horizontally.

7. An apparatus according to claim 1, wherein the drying chamber (4) is divided into three regions, a pre-heating and mixing region (V), which is arranged immediately downstream of the entrance (5), followed by a heating region (H), which is optionally divided into the three heating zones (I, II, III), and a cooling region (K), which is arranged before the exit (6) of the drying chamber (4).

8. A coating installation for board-shaped piece material, especially for in-layers or printed circuit boards, comprising a coating station (2), in which the board-shaped piece material is coated on one or both sides with photoresist or the like, and an adjoining drying station (3), in which the photoresist is dried and solvent contained in the photoresist is evaporated off and transported away, wherein the drying station (3) is a continuous drier according to any one of claims 1 to 7.

9. A coating installation according to claim 8, wherein the coating station (2) comprises a coating cabin (20) having an air inlet opening (23) and an entry opening (21) and an opposite exit opening (22) for the board-shaped material to be coated, the exit opening (22) leading directly into the entrance (5) to the drying chamber (4).

10. A coating installation according to claim 9, wherein the coating station (2) is equipped with a roller coating device (24) comprising one coating roller arranged above and one coating roller arranged below the transport path (P) of the board-shaped piece material, between which the board-shaped piece material can be transported for coating with photoresist or the like while being held at its longitudinal edges by transport means provided in the coating station (2).

11. A coating installation according to claim 9, wherein the outlet opening (8) provided in the continuous drier (3) for the outgoing air (A) is at the same time the air outlet opening for the coating cabin (20).

12. A coating installation according to claim 11, wherein the volume of outgoing air (A) removed at the outlet opening (8) approximately corresponds to the air volumes of the drying air (L) passed through the drying chamber (4) and the air (F) introduced into the coating cabin (20).

13. A coating installation according to claim 12, wherein the air inlet opening (23) of the coating cabin (20) is equipped with a clean-room filter (25).

14. A coating installation according to claim 13, wherein the mixing ratio of hot outgoing air from the drying chamber (4) and cold outgoing air from the coating cabin (20) is selected to be such ihat the outgoing air (A) at the outlet opening (8) has a temperature of approximately from 30°C to 70°C.

15. A coating installation according to claim 11, wherein the air is guided in the installation in such a manner that there is a slight over-pressure inside the coating cabin (20) in the region of the entry opening (21) and inside the drying chamber (4) in the region of the exit (6) for the board-shaped piece material, so that the installation is substantially isolated from the surrounding air.

## Revendications

1. Sécheur en continu pour des articles en forme de plaques, notamment pour des couches intérieures enduites de plaquettes à circuits imprimés, comportant une chambre de séchage (4), dans laquelle l'article en forme de plaque à sécher est soumis à un courant d'air (L) guidé de façon forcée, alors qu'il est transporté par des moyens de transport qui s'appliquent de préférence sur ses bords longitudinaux, le long d'une voie de transport (P) depuis une entrée (5) jusqu'à une sortie (6) de la chambre de séchage (4), et comportant une entrée (7) et une sortie (8) pour l'air (L), et dans lequel au-dessus de la voie de transport de l'article en forme de plaque sont disposés des radiateurs à infrarouge, et le courant d'air dans la chambre de séchage est guidé de façon forcée en sens opposé de la direction de transport de l'article en forme de plaque et essentiellement parallèlement au plan de transport,
caractérisé en ce
qu'au-dessus et au-dessous de la voie de transport (P) de l'article en forme de plaque sont disposés des émetteurs à infrarouge (9), dont le rayonnement agit directement sur l'article pour sécher ce dernier, et qui forment simultanément une source de chaleur pour le courant d'air (L) guidé de façon forcée,
que le courant d'air (L) est essentiellement laminaire dans la chambre de séchage (4), et
que les radiateurs à infrarouge (9) disposés au-dessus et au-dessous de la voie de transport (P) le long de cette dernière peuvent être réunis par groupes et fonctionner de telle sorte que la chambre de séchage (4) possède, le long de la voie de transport (P), plusieurs, de préférence trois zones de chauffage (I, II, III), qui possèdent chacune un groupe de radiateurs à infrarouge (9) possédant une température superficielle variable, la zone de chauffage (I), dans laquelle les radiateurs à infrarouge (9) possèdent la température superficielle la plus faible, étant les plus proches de l'entrée (5) de la chambre de séchage (4), tandis que la zone de chauffage (III), dans laquelle les radiateurs à infrarouge (9) possèdent la température superficielle maximale, est la dernière zone de chauffage avant la sortie (6).

2. Dispositif selon la revendication 1, caractérisé en ce que les radiateurs à infrarouge (9) sont disposés à des distances identiques les unes des autres le long de la voie de transport (P), la distance entre deux radiateurs à infrarouge (9) étant comprise entre environ 70 mm et environ 130 mm et étant égale de préférence à environ 100 mm.

3. Dispositif selon la revendication 1, caractérisé en ce que la sortie d'air (8) est conçue pour le tirage d'une quantité d'air plus importante que celle qui est envoyée à l'entrée d'air (7).

4. Dispositif selon la revendication 1, caractérisé en ce que l'entrée (7) pour l'envoi d'air (Z) est disposée dans la zone de la sortie (6) de la chambre de séchage (4), tandis que la sortie (8) pour l'air sortant (A) est disposée dans la zone de l'entrée (5) de la chambre de séchage (4), et que des régulateurs de débit d'air (12;14) sont prévus à l'entrée (7) et à la sortie (8).

5. Dispositif selon la revendication 4, caractérisé en ce qu'un filtre de salle blanche (10) est disposé dans l'entrée (7) pour l'air arrivant (Z).

6. Dispositif selon la revendication 1, caractérisé en ce que la voie de transport (P) de l'article en forme de plaque s'étend sensiblement horizontalement à l'intérieur de la chambre de séchage (4).

7. Dispositif selon la revendication 1, caractérisé en ce que la chambre de séchage (4) est subdivisée en trois zones, une zone de préchauffage et de mélange (B), qui est située directement en aval de l'entrée (5), une zone de chauffage (S) qui succède à la zone précédente et est également subdivisée en les trois zones (I, II, III) et une zone de refroidissement (K) qui est disposée en amont de la sortie (6) de la chambre de séchage (4).

8. Installation d'enduction pour des articles en forme de plaques, notamment pour des couches intérieures ou des plaquettes à circuits imprimés, comportant un poste d'enduction (2), dans lequel l'article en forme de plaque est recouvert d'une photolaque ou analogue sur une face ou sur ses deux faces, et comportant un poste de séchage (3) succédant au poste d'enduction et dans lequel la photolaque est séchée et le solvant contenu dans la photolaque est évaporé ou évacué, caractérisée en ce que le poste de séchage (3) est un sécheur en continu selon l'une des revendications 1-7.

9. Installation d'enduction selon la revendication 8, caractérisée en ce que le poste d'enduction (2) est une cabine d'enduction (20) comportant une ouverture pour l'air arrivant (23) et une ouverture d'entrée (21) et une ouverture de sortie opposée (22) pour l'article en forme de plaque devant être enduit, l'ouverture de sortie (22) débouchant directement dans l'entrée (5) de la chambre de séchage (4) .

10. Installation d'enduction selon la revendication 9, caractérisée en ce que le poste d'enduction (2) est équipé d'un dispositif d'enduction à rouleaux (24), qui comprend un rouleau d'enduction disposé au-dessus de la voie de transport (P) de l'article en forme de plaque, et un rouleau d'enduction disposé au-dessous de cette voie de transport, rouleaux entre lesquels l'article en forme de plaque est placé pour son enduction avec une photolaque ou analogue, l'article étant retenu au niveau des bords longitudinaux par des moyens de transport prévus dans le poste d'enduction (2).

11. Installation d'enduction selon la revendication 9, caractérisée en ce que l'ouverture de sortie (8) prévue dans le sécheur en continu (3) pour l'air sortant (A) est simultanément l'ouverture de sortie d'air pour la cabine d'enduction (20).

12. Installation d'enduction selon la revendication 11, caractérisée en ce que le volume d'air sortant (A), qui sort au niveau de l'ouverture de sortie (8), correspond approximativement aux volumes de l'air de séchage (L) envoyé à travers la chambre de séchage (20) et de l'air (F) introduit dans la cabine d'enduction (20).

13. Installation d'enduction selon la revendication 12, caractérisée en ce que l'ouverture d'arrivée d'air (23) de la cabine d'enduction (20) est équipée d'un filtre (25) pour salle blanche.

14. Installation d'enduction selon la revendication 13, caractérisée en ce que le rapport du mélange d'air sortant chaud provenant de la chambre de séchage (4) et de l'air sortant froid provenant de la cabine d'enduction (20) est choisi de telle sorte que l'air sortant (A) présent au niveau de l'ouverture de sortie (8) possède une température d'environ 30°C-70°C.

15. Installation d'enduction selon la revendication 11, caractérisée en ce que le guidage de l'air dans l'installation s'effectue de telle sorte qu'une légère surpression règne à l'intérieur de la cabine d'enduction (20) dans la zone de l'ouverture d'entrée (21) et à l'intérieur de la chambre de séchage (4) dans la zone de la sortie (6) pour l'article en forme de plaque, de sorte que l'installation est essentiellement séparée de l'air environnant.
